# EUROPÄISCHE PATENTANMELDUNG

(11) **EP 1 284 590 A1**
(43) Veröffentlichungstag der Anmeldung: **19.02.2003**
(21) Anmeldenummer: 02405656.6
(22) Anmeldetag: 28.07.2002
(51) Int. Cl.: H05K 3/32, H01R 12/22

(54) **Vorrichtungen zur Kontaktierung von Anschlussleitungen mittels eines eleastischen, geschichteten Verbindungselementes**

(30) Priorität: 14.08.2001 CH 15002001
(71) Anmelder: Swissvoice AG, 4614 Hägendorf (CH)
(72) Erfinder: Baiker, Stefan, 4059 Basel (CH)
(74) Vertreter: RUTZ ISLER & PARTNER

(57) **Zusammenfassung**

Die Vorrichtung dient zur gegenseitigen Kontaktierung von Anschlussleitungen (21, 31) von wenigstens zwei elektronischen Modulen (4, 5) mittels eines alternierend leitfähige und isolierende Schichten (10, 11) aufweisenden Zebraleitgummis (1), welches zwischen mit den Anschlussleitungen (21, 31) verbundenen Anschlusskontakten (2, 3) derart komprimiert wird, dass die einander zugehörigen Anschlusskontakte (2, 3) mittels leitfähigen Schichten (10) miteinander verbunden werden. Erfindungsgemäss sind die Anschlusskontakte (2, 3) eines oder beider Module (4, 5) mit Vertiefungen und/oder Rinnen (23) versehen, die zur Aufnahme und gegebenenfalls zur Ableitung von Flüssigkeit geeignet sind, die aus dem Zebraleitgummi (1) austreten und Kontaktprobleme verursachen kann.

## Beschreibung

Die Erfindung betrifft eine Vorrichtung zur Kontaktierung von Anschlussleitungen elektronischer Module mittels eines elastischen Verbindungselementes nach dem Oberbegriff des Patentanspruchs 1.

Zur Verbindung von Modulen elektronischer Geräte werden oft elastische, elektrisch leitfähige Verbindungselemente verwendet, die zwischen Anschlusskontakten positioniert und durch gegenseitiges Andrücken der betreffenden Module fixiert werden.

Derartige elastische und elektrisch leitfähige Verbindungselemente sind beispielsweise aus [1], U.S. Patentschrift No. 5,599,193 und [2], U.S. Patentschrift No. 5,517,752 bekannt.

In [1] sind Verbindungselemente beschrieben, die ein nicht-leitendes Substrat aufweisen, welches beidseitig mit elektrisch leitenden Schichten versehen ist, die mittels elektrischen Leitungen miteinander verbunden sind, so dass eine elektrische Verbindung zwischen Anschlusskontakten von Modulen entsteht, an denen die elektrisch leitenden Schichten anliegen.

Vorzugsweise sind die Oberflächen der elektrisch leitenden Schichten aufgeraut, so dass bei der Montage allenfalls vorhandene Oxydschichten an den Anschlusskontakten, die störende Übergangswiderstände bilden können, aufgebrochen werden.

In [2] ist ein Verbindungselement beschrieben, welches aus elastischem, mit elektrisch leitenden Partikeln versehenem Verbindungsmaterial besteht, welches während der Montage unter erhöhter Temperatur komprimiert wird, so dass leitende Partikel zwischen einander zugehörigen Anschlusskontakten zusammengepresst werden. Die Anschlusskontakte sind mit Furchen versehen, die bei der Montage unter Einwirkung äusserer Kräfte vollständig deformiert und mit elastischem Verbindungsmaterial gefüllt werden, das unter Einwirkung von Druck und Wärme im komprimierten Zustand verhärtet.

Die in [1] und [2] beschriebenen Verfahren zur Verbindung von Anschlusskontakten mittels elastischen Verbindungselementen sind verhältnismässig aufwendig anzuwenden, weshalb oft die Verwendung elastischer, geschichteter Verbindungselemente bevorzugt wird, wie sie in [3], U.S. Patentschrift No. 4,408,814 sowie in [4], U.S. Patentschrift No. 4,422,728 oder [5], der Offenlegungsschrift DE 37 01 310 A1 beschrieben sind. Ein solches elastisches, geschichtetes Verbindungselement, das in [5] und auch nachstehend als Zebraleitgummi bezeichnet wird, weist alternierend, miteinander verbundene, leitfähige und isolierende Schichten mit geringem Durchmesser auf, die derart zwischen Anschlusskontakten angeordnet und in Längsrichtung komprimiert werden, dass zwei zueinander korrespondierende Anschlusskontakte vorzugsweise mittels wenigstens zwei leitfähigen Schichten miteinander verbunden werden.

Eine elektrisch leitfähige Schicht besteht beispielsweise aus 60 Gewichtsanteilen Siliziumkautschuk aus Organopolysiloxan-Gummi, 40 Gewichtsanteilen Acetylenruss, 5 Gewichtsanteilen Kohlenstofffasern und 3 Gewichtsanteilen eines Härtungsmittels (siehe [3], Spalte 7). Anstelle von elektrisch leitenden Kohlenstofffasern werden oft auch Metalldrähte oder Kugeln verwendet, die mit einem Edelmetall wie Gold; Silber oder einem Silberoxyd beschichtet sind. Die Herstellung von Organopolysiloxan-Gummi ist beispielsweise in [6], U.S. Patentschrift No. 6,214,962 beschrieben.

Bei der Verwendung von Zebraleitgummi, beispielsweise bei der in [4] beschriebenen Verbindung einer Flüssigkristallanzeige mit einer Leiterplatte, wurden nun, insbesondere nach längerer Betriebsdauer, verschiedentlich Kontaktierungsprobleme festgestellt, die Funktionsmängel der betroffenen Module zur Folge hatten. Bei Flüssigkristallanzeigen traten aufgrund von Übergangswiderständen, die nach der Montage kontinuierlich angestiegen waren, störende Kontrastverluste auf. Ein Auftreten dieser Mängel konnte auch bei erhöhter Kompression sowie optimaler Ausrichtung der Schichten des Zebraleitgummis 1 zwischen den betreffenden Anschlusskontakten, bei der eine maximale Anzahl von leitenden Schichten wirksam wird, beobachtet werden.

Der vorliegenden Erfindung liegt daher die Aufgabe zugrunde, eine Vorrichtung zur Kontaktierung von Anschlussleitungen elektronischer Module mittels eines Zebraleitgummis anzugeben, bei der die beschriebenen Kontaktierungsprobleme vermieden werden.

Insbesondere sollte eine mit einem Zebraleitgummi versehene Kontaktierungsvorrichtung geschaffen werden, mittels der Verbindungsleitungen, besonders auch bei der Montage gemäss Richtlinien der Hersteller, dauerhaft mit geringem und konstantem Übergangswiderstand miteinander verbindbar sind.

Diese Aufgabe wird mit einer Kontaktierungsvorrichtung gelöst, welche die in Anspruch 1 angegebenen Merkmale aufweist. Vorteilhafte Ausgestaltungen der Erfindung sind in weiteren Ansprüchen angegeben.

Die Vorrichtung erlaubt die gegenseitige Kontaktierung von Anschlussleitungen von wenigstens zwei elektronischen Modulen mittels eines alternierend leitfähige und isolierende Schichten aufweisenden Zebraleitgummis, welches zwischen mit den Anschlussleitungen verbundenen Anschlusskontakten derart komprimiert wird, dass einander zugehörige Anschlusskontakte mittels leitfähigen Schichten miteinander verbunden werden. Erfindungsgemäss sind die Anschlusskontakte eines oder beider Module mit Vertiefungen oder Rinnen versehen, die zur Aufnahme und gegebenenfalls zur Ableitung von Flüssigkeit geeignet sind, die aus dem Zebraleitgummi austreten und Kontaktprobleme verursachen kann.

Ferner werden durch die Vertiefungen oder Rinnen auch weitere Verschmutzungen, beispielsweise Handcreme, aufgenommen, die während der Herstellung oder Montage auf die Kontaktflächen gelangen können.

Die Vertiefungen oder Rinnen, die während der Fertigung eingeprägt oder anschliessend durch Aufrauen, Fräsen oder Schneiden der Oberflächen der Anschlusskontakte eingearbeitet werden, sind vorzugsweise derart schmal ausgestaltet, dass das elastische Material des Zebraleitgummis nach dessen Kompression nicht oder nur teilweise darin eintreten kann, wodurch diese gefüllt und das Ableiten von Flüssigkeit verhindert würden.

Wesentlich bei diesen Rinnen und/oder Vertiefungen, gegebenenfalls auch Bohrungen oder Löchern, ist daher, dass die austretende Flüssigkeit aufgenommen und abgeleitet werden kann.

Das Aufbringen der Rinnen oder Vertiefungen kann auch durch das Auftragen mehrer entsprechend ausgestalteter Indium-Zinn-Oxyd-Schichten oder durch Fräsen oder Schneiden beispielsweise mittels eines Laserstrahls erfolgen.

Weiterhin können Rinnen oder Kanäle geschaffen werden, indem eine Schicht, gegebenenfalls eine Metall- oder Graphitschicht auf die Kontaktfläche aufgetragen wird, in der grössere Partikel, gegebenenfalls Metallkügelchen derart eingebunden sind, dass die austretende Flüssigkeit versickern kann.

Die Rinnen werden vorzugsweise quer zu den Schichten des Zebraleitgummis angeordnet, so dass auch leitfähige Schichten, die sich im Randbereich der Anschlusskontakte befinden, möglichst unterbruchsfrei mit diesen verbunden werden und ausgetretene Flüssigkeit über kurze Distanz abgeleitet werden kann.

In einer vorzugsweisen Ausgestaltung der Erfindung sind die Rinnen derart ausgestaltet, dass deren Breite zum Rand des Anschlusskontaktes hin zunimmt, wodurch die Ableitung aus dem Zebraleitgummi austretender Flüssigkeit erleichtert wird.

Flüssigkeit, die aus dem Zebraleitgummi austreten und auf Kontaktflächen eine Isolationsschicht bilden kann, wird erfindungsgemäss daher mit einfachen Massnahmen kanalisiert und abgeleitet, wobei eine optimale Verbindung zwischen den leitfähigen Schichten des Zebraleitgummis gewährleistet und andauernd erhalten wird.

Besonders vorteilhaft sind erfindungsgemässe Kontaktierungsvorrichtungen bei der Kontaktierung von Modulen einsetzbar, die nach der Chip-on-Glass Technologie gefertigt und beispielsweise mit aufgedampften Anschlusskontakten aus Indium-Zinn-Oxyd versehen sind. Durch Einfügen von Rinnen auf die ansonsten glatten Anschlusskontakte werden Kontaktierungsprobleme vermieden.

Erfindungsgemässe Kontaktierungsvorrichtungen sind weitgehend unabhängig von der Beschaffenheit des Zebraleitgummis und den gewählten Monatageparametern vorteilhaft einsetzbar. Beispielsweise sind Zebraleitgummis verwendbar, die mit Kohlenstofffasern oder mit gegebenenfalls mit Edelmetallen wie Gold, Silber oder Silberoxyd beschichteten Kügelchen oder Partikeln aus Metall- oder Kunststoff versehen sind. Besonders vorteilhaft sind erfindungsgemässe Kontaktierungsvorrichtungen zudem bei der Wahl höherer Kompressionsfaktoren einsetzbar.

Nachfolgend wird die Erfindung anhand von Zeichnungen näher erläutert. Dabei zeigt :
- Figur 1: eine Kontaktierungsvorrichtung mit erfindungsgemäss ausgestalteten Anschlusskontakten, die mittels eines Zebraleitgummis miteinander verbunden werden,
- Figur 2: einen Anschlusskontakt einer bekannten, ein Zebraleitgummi verwendenden Kontaktierungsvorrichtung nach längerer Betriebsdauer,
- Figur 3: einen Anschlusskontakt der Kontaktierungsvorrichtung gemäss Figur 1 nach längerer Betriebsdauer und

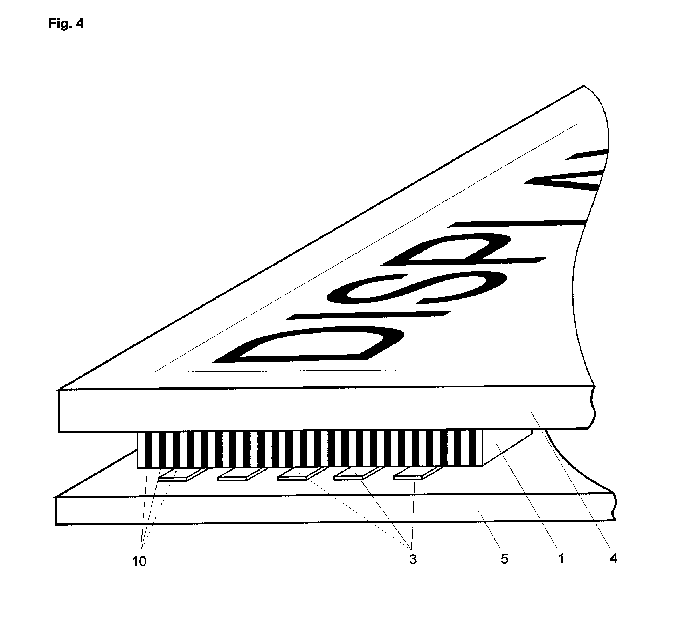

- Figur 4: die erfindungsgemässe Kontaktierungsvorrichtung von Figur 1, mittels der eine Flüssigkristallanzeige mit einer Leiterplatte verbunden ist.

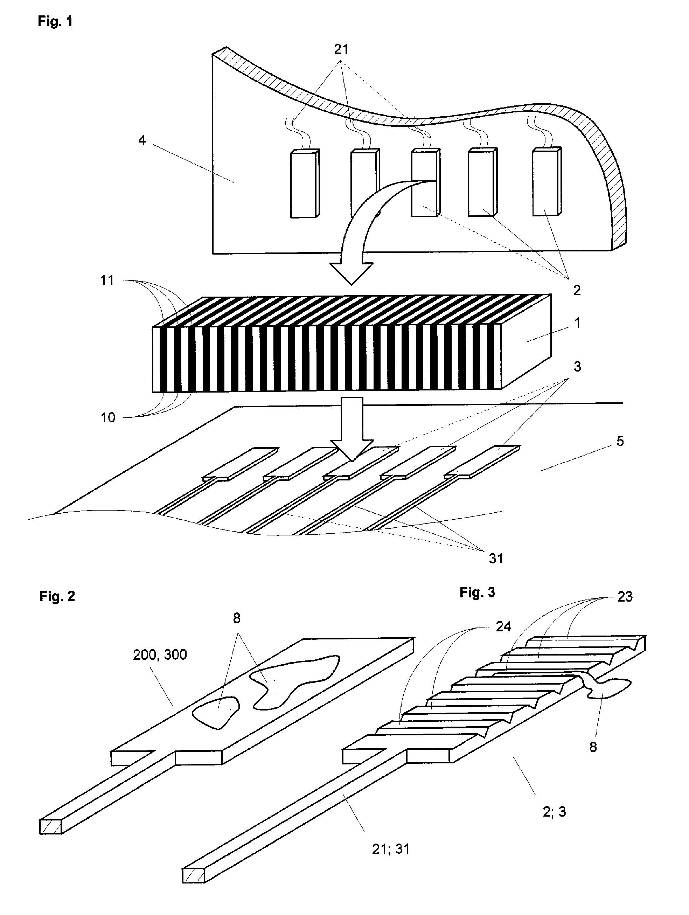

Figur 1 zeigt den Anschlussbereich von zwei Modulen 4, 5 mit je fünf Anschlusskontakten 2 bzw. 3, die mittels eines elastischen Zebraleitgummis 1 miteinander verbunden werden. Das Zebraleitgummi 1, das bei der Montage vorzugsweise um wenigstens 10% komprimiert wird, weist alternierend miteinander verbundene leitfähige und isolierende Schichten 10, 11 geringen Durchmessers auf. Wie in Figur 3 gezeigt, sollten nach der Montage zueinander korrespondierende Kontakte 2, 3 mittels wenigstens zwei leitfähigen Schichten 10 miteinander verbunden sein.

Durch die Elastizität und eine verhältnismässig geringe Kompression des Zebraleitgummis 1 schmiegt sich dieses an die Anschlusskontakte 2, 3 an, so dass unmittelbar nach der Montage eine gute Kontaktierung vorhanden ist.

Das Zebraleitgummi 1 weist daher nicht, wie bei der in [1] beschriebenen Vorrichtung, ein nicht-leitendes Substrat auf, welches beidseitig mit Kontaktfolien versehen ist, durch die bei hoher Kompression Oxydschichten aufgebrochen werden können, sondern durchgehende leitfähige Schichten 10.

Die auf das Verbindungselement bzw. das Zebraleitgummi 1 ausgeübte Kompressionskraft ist ferner viel geringer als bei der in [2] beschriebenen Vorrichtung, bei der einige im Substrat gleichmässig verteilte Metallpartikel zwischen den Anschlusskontakten in darin enthaltene Furchen gepresst werden und dadurch die betreffenden Anschlusskontakte miteinander verbinden.

Bei der Verwendung eines Zebraleitgummis 1, das nur schwach komprimiert wird, treten die in [1] und [2] beschriebenen Effekte nicht auf. Es werden keine Oxydschichten aufgebrochen oder Metallpartikel gepresst, so dass die Verwendung von Furchen oder Rinnen, die in die Anschlusskontakte eingeprägt werden, überflüssig oder gar nachteilig erscheint. Obwohl sich diese Feststellung unmittelbar nach der Montage eines Zebraleitgummis 1 zuerst bestätigt, wurden nach längerer Betriebsdauer Probleme bei der Kontaktierung einzelner Module 4, 5 festgestellt. Insbesondere bei nach der Chip-on-Glass (nachstehend COG) Technologie hergestellten Modulen, die besonders glatte und aus der Sicht des Fachmanns daher besonders gute Anschlusskontakte 2 aufweisen, wurden Kontaktierungsprobleme festgestellt.

Die COG-Technologie, welche die direkte Verbindung elektronischer Komponenten mit einem metallisierten Glassubstrat erlaubt, wird oft zur Herstellung von Flüssigkristallanzeigen (LCD) angewendet (siehe Mool C. Gupta, Handbook of PHOTONICS, CRC Press LLC, Boca Raton 1997, Seiten 780-788). Da die vorzugsweise aus Indium-Zinn-Oxyd gefertigten Anschlusskontakte 2 eines COG-Moduls nicht lötbar sind, werden diese normalerweise mittels eines Zebraleitgummis 1 verbunden.

Bei derart kontaktierten COG-Flüssigkristallanzeigen wurden nach längerer Betriebsdauer oft Kontrastverluste oder weitere Störungen festgestellt, die meist abhängig von der Beschaffenheit des Zebraleitgummis 1 waren. Untersuchungen haben dabei ergeben, dass aus dem Zebraleitgummi 1 austretende Flüssigkeiten auf den Anschlusskontakten 2, 3 isolierende Schichten bilden können, welche den Betrieb der Module 4, 5 beeinträchtigen.

Es wurde festgestellt, dass Zebraleitgummi insbesondere dann eine ölige, silikonartige Flüssigkeit absondert, wenn das Aushärten oder Ausbacken aller Schichten des Zebraleitgummis während der Herstellung nur unvollständig erfolgt ist. Eine Optimierung des Zebraleitgummis würde jedoch eine Verlängerung der Herstellungsprozesse verursachen, wodurch entsprechend höhere Herstellungskosten resultieren würden.

Figur 2 zeigt einen konventionellen glatten Anschlusskontakt 200, 300, der mit einer durch austretende Flüssigkeit verursachten isolierenden Schicht 8 bedeckt ist, welche einen erhöhten Übergangswiderstand verursacht, aufgrund dessen die erwähnten Funktionsstörungen entstehen.

Figur 3 zeigt einen Anschlusskontakt 2; 3 der erfindungsgemässen Kontaktierungsvorrichtung gemäss Figur 1 nach längerer Betriebsdauer. Der Anschlusskontakt 2; 3 ist mit Rinnen 23 versehen, mittels denen Flüssigkeit, die aus dem Zebraleitgummi 1 ausgetreten ist, kanalisiert und weggeleitet wurde, so dass eine entsprechende Isolationsschicht 8 nicht auf den verbleibenden Kontaktflächen 24, sondern neben dem Anschlusskontakt 2; 3 auf dem Substrat des zugehörigen Moduls 4; 5 gebildet wurde. Die Rinnen 23 sind schmal ausgestaltet, so dass der resultierende Querschnittverlust vergleichsweise gering ist im Verhältnis zum Querschnittverlust, der ansonsten durch Isolationsschichten 8 ausgetretener Flüssigkeiten verursacht werden kann.

Die Rinnen 23 sind vorzugsweise so schmal ausgestaltet, dass das elastische Material des Zebraleitgummis 1 nicht oder nur teilweise in diese eintreten kann, wodurch ein Unterbruch der Ableitung von gegebenenfalls aus dem Zebraleitgummi 1 austretender Flüssigkeit verhindert wird.

Die Rinnen 23 werden in einer vorzugsweisen Ausgestaltung zudem quer zu den Schichten 10, 11 des Zebraleitgummis 1 angeordnet, so dass auch leitfähige Schichten 10, die sich im Randbereich der Anschlusskontakte 2, 3 befinden, möglichst unterbruchsfrei mit diesen verbunden sind und austretende Flüssigkeit über kurze Distanz abgeleitet werden kann.

Die optimale elektrische Verbindung des Zebraleitgummis 1 mit den Anschlusskontakten 2, 3 bleibt daher auch nach längerer Betriebsdauer gewährleistet.

Rinnen 23 werden vorzugsweise bei der Herstellung der Anschlusskontakte 2, 3 in diese eingeprägt. Möglich ist ferner ein Aufrauen der Oberfläche der Anschlusskontakte 2, 3 nach deren Herstellung. Das Aufbringen der Rinnen oder Vertiefungen kann auch durch das Auftragen mehrer entsprechend ausgestalteter Indium-Zinn-Oxyd-Schichten oder durch Fräsen oder Schneiden der Oberfläche der Anschlusskontakte 2, 3 beispielsweise mittels eines Laserstrahls erfolgen.

Die Ausgestaltung der Rinnen 23 kann ferner in Abhängigkeit der Beschaffenheit des Zebraleitgummis 1 erfolgen.

### Literaturverzeichnis

- [1]: U.S. Patentschrift No. 5,599,193
- [2]: U.S. Patentschrift No. 5,517,752
- [3]: U.S. Patentschrift No. 4,408,814
- [4]: U.S. Patentschrift No. 4,422,728
- [5]: Offenlegungsschrift DE 37 01 310 A1
- [6]: U.S. Patentschrift No. 6,214,962
- [7]: Mool C. Gupta, Handbook of PHOTONICS, CRC Press LLC, Boca Raton 1997

## Patentansprüche

1. Vorrichtung zur gegenseitigen Kontaktierung von Anschlussleitungen (21, 31) von wenigstens zwei elektronischen Modulen (4, 5) mittels eines alternierend leitfähige und isolierende Schichten (10, 11) aufweisenden Zebraleitgummis (1), welches zwischen mit den Anschlussleitungen (21, 31) verbundenen Anschlusskontakten (2, 3) derart komprimiert wird, dass die einander zugehörigen Anschlusskontakte (2, 3) mittels leitfähigen Schichten (10) miteinander verbunden werden, **dadurch gekennzeichnet, dass** die Anschlusskontakte (2, 3) eines oder beider Module (4, 5) mit Vertiefungen und/oder Rinnen (23) versehen sind.

2. Kontaktierungsvorrichtung nach Anspruch 1, **dadurch gekennzeichnet, dass** die Vertiefungen oder Rinnen (23) derart ausgestaltet sind, dass sie zur Aufnahme und gegebenenfalls Ableitung von Verunreinigungen und von Flüssigkeit geeignet sind, die aus dem Zebraleitgummi (1) austreten kann.

3. Kontaktierungsvorrichtung nach Anspruch 1 oder 2, **dadurch gekennzeichnet, dass** die Vertiefungen oder Rinnen (23) derart ausgestaltet sind, dass das elastische Material des Zebraleitgummis (1) nach dessen Kompression nicht oder nur teilweise in die Rinnen (23) eintreten kann.

4. Kontaktierungsvorrichtung nach Anspruch 1, 2 oder 3, **dadurch gekennzeichnet, dass** die Vertiefungen oder Rinnen (23) im Wesentlichen quer zu den Schichten (10, 11) des Zebraleitgummis (1) verlaufen und sich gegebenenfalls zum Rand der Kontaktfläche hin verbreitern.

5. Kontaktierungsvorrichtung nach Anspruch 1, 2, 3 oder 4, **dadurch gekennzeichnet, dass** die leitfähigen Schichten (10) des Zebraleitgummis (1) mit Kohlenstofffasern, oder mit Metallkugeln versehen sind, welche gegebenenfalls mit Edelmetallen wie Gold, Silber oder Silberoxyd beschichtet sind.

6. Kontaktierungsvorrichtung nach einem der Ansprüche 1 bis 5, **dadurch gekennzeichnet, dass** wenigstens eines der Module (4) in Chip-on-Glass Technik gefertigt ist und aufgedampfte Elektroden aufweist, die als Anschlusskontakte (2) dienen.

7. Kontaktierungsvorrichtung nach einem der Ansprüche 1 bis 6, **dadurch gekennzeichnet, dass** eines der Module (4) eine Flüssigkristallanzeige ist.

8. Kontaktierungsvorrichtung nach einem der Ansprüche 1 bis 7, **dadurch gekennzeichnet, dass** die Vertiefungen oder Rinnen (23) gleichzeitig mit der Herstellung der Anschlusskontakte (2, 3) oder anschliessend in diese eingeprägt wurden.

9. Kontaktierungsvorrichtung nach Anspruch 8, **dadurch gekennzeichnet, dass** die Vertiefungen oder Rinnen (23)
a) durch Aufrauen der Oberfläche in die Anschlusskontakte (2; 3) eingeprägt wurden;
b) durch Auftragen zusätzlicher und entsprechend gestalteter Schichten, beispielsweise Indium-Zinn-Oxyd-Schichten, auf die Anschlusskontakte (2; 3) geschaffen werden;
c) durch Auftragen einer zusätzlichen, gegebenenfalls aus Metall oder Graphit bestehenden Schicht auf die Anschlusskontakte (2; 3) geschaffen werden, in welcher Schicht grössere Partikel, gegebenenfalls Metallkügelchen eingebunden sind;
d) durch Fräsen oder Schneiden gegebenenfalls mittels eines Lasers auf die Anschlusskontakte (2; 3) aufgetragen wurden.

10. Kontaktierungsvorrichtung nach einem der Ansprüche 1 bis 9, **dadurch gekennzeichnet, dass** die Ausgestaltung der Rinnen (23) in Abhängigkeit der Beschaffenheit des Zebraleitgummis 1 gewählt ist.
